(19) Europäisches Patentamt
European Patent Office
Office européen des brevets

(11) Veröffentlichungsnummer: **0 143 951**
**B1**

# (12) EUROPÄISCHE PATENTSCHRIFT

(45) Veröffentlichungstag der Patentschrift: **08.02.89**

(51) Int. Cl.[4]: **C 23 C 18/28**, C 23 C 18/16

(21) Anmeldenummer: **84112179.1**

(22) Anmeldetag: **11.10.84**

## (54) Verfahren zur chemischen Metallisierung.

(30) Priorität: **18.10.83 DE 3337790**

(43) Veröffentlichungstag der Anmeldung:
**12.06.85 Patentblatt 85/24**

(45) Bekanntmachung des Hinweises auf die Patenterteilung:
**08.02.89 Patentblatt 89/6**

(84) Benannte Vertragsstaaten:
**DE FR GB IT**

(56) Entgegenhaltungen:
**FR-A- 2 388 459**
**US-A- 3 964 906**

(73) Patentinhaber: **Licentia Patent-Verwaltungs-GmbH, Theodor-Stern-Kai 1, D-6000 Frankfurt/Main 70 (DE)**

(72) Erfinder: **Gemmler, Armin, Dr.rer.nat., Aachtalstrasse 40, D-7902 Blaubeuren-Weiler (DE)**

(74) Vertreter: **Schulze, Harald Rudolf, Dipl.-Ing. et al, Licentia Patent-Verwaltungs-GmbH Theodor-Stern-Kai 1, D-6000 Frankfurt/Main 70 (DE)**

**EP 0 143 951 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur chemischen Metallisierung nach dem Oberbegriff des Patentanspruchs 1. Insbesondere betrifft sie ein Verfahren zur Herstellung von gedruckten Schaltungen, auch Leiterplatten genannt, die in der Elektroindustrie verwendet werden.

Die Herstellung von Leiterplatten für die Elektronik erfolgt derzeit noch zum überwiegenden Teil nach der sogenannten Substraktivtechnik. Dabei wird von ganzflächig kupferkaschierten Kunststoff-Basismaterialien ausgegangen, auf denen das Leiterbild durch Wegätzen des überflüssigen Kupfers entsteht, das bis zu 80% des Gesamtkupfers betragen kann. Einer nachteiligen Unterätzung der metallischen Leiterbahnen kann nur teilweise durch Kompensation im Leiterbild und/oder durch Flankenschutz der Leiterbahnen begegnet werden. Zur Markierung des zu ätzenden Oberflächenmusters sind organische Fotoresistschichten und zum Teil zusätzliche Metallresistauflagen notwendig. Seit einigen Jahren bahnt sich die Einführung der sogenannten Semiadditivtechnik an, die mit zwei Dritteln der Verfahrensschritte der Substrativtechnik auskommt, weniger Kupferabfälle produziert, dafür aber noch auf Maskier- und Ätzprozesse angewiesen ist.

Diese Nachteile entfallen bei der sogenannten Volladditivtechnik, insbesondere bei der lackfreien Fotoadditivvariante, welche das am meisten rohstoffsparende und umweltfreundliche Verfahren darstellt. Vereinfacht lässt sich die Fotoadditivtechnik in ein Verfahrensschema aufgliedern, welches das Basismaterial und dessen Vorbehandlung, die Bildübertragung einschliesslich einer selektiven Aktivierung sowie die abschliessende Metallisierung umfasst.

Ein wichtiger Schritt bei der beispielsweisen Herstellung von Leiterplatten ist die Übertragung des Leiterbahnmusters von einer Vorlage auf das Leiterplatten-Basismaterial. In der Fotoadditivtechnik muss dazu auf die Leiterplattenoberfläche ein Sensibilisator aufgebracht werden, der durch selektives Belichten an den vom Licht getroffenen Stellen aktiviert oder desaktiviert wird. Auf den aktivierten Abschnitten können in einer Edelmetallsalzlösung Edelmetallkeime abgeschieden werden, die dann in einem aussenstromlos arbeitenden Metallisierungsbad metallisiert werden können.

Der aktivierte Sensibilisator auch Sensitizer genannt, spielt eine Schlüsselrolle bei den verschiedenen Verfahren der Fotoadditivtechnik. So ist in der DE-AS 1 917 474 u.a. ein Sensitizer beschrieben, der ein Zinn(II)-salz enthält. Dieses Zinn(II)-salz wird von UV-Licht in Zinn(IV) überführt, das dann nicht mehr imstande ist, z.B. Palladiumchlorid in wässriger Lösung zu Palladiumkeimen zu reduzieren. Nachteil dieser Zinn(II)-haltigen Sensitizer ist ihre Oxidationsempfindlichkeit gegenüber Luftsauerstoff. So werden Lösungen von Zinn(II)-salzen an Luft zu Zinn(IV)-salzen oxidiert, die in wässrigen Lösungen hydrolisieren und mehrkernige Zinnoxidhydrate ergeben, die sich als gallertartiger farbloser Niederschlag am Gefässboden absetzen. Der Zinn(II)-Gehalt einer solchen Lösung nimmt also zeitlich fortlaufend ab. Ohne ein Angleichen der Belichtungszeiten und/oder ein Konstanthalten der Zinn(II)-Konzentration würden sich Unterstrahlungen und/oder Reflexionen zwischen Belichtungsmaske und Basismaterial störend auswirken, insbesondere beim Aufbau von Fein- und Feinstleitern. Titan- und Bleisalze verhalten sich ähnlich wie Zinnsalze.

In der DE-AS 1 917 474 wird ausserdem ein Eisen(III)-oxalat-Photopromotor erwähnt, dessen Reaktion unter dem Einfluss aktinischer Strahlung folgendermassen ablaufen soll:

$Fe_2(C_2O_4)_3 \rightarrow 2FE^{3+} + 3\,(C_2O_4)^{2-}$

$(C_2O_4)^{2-} \rightarrow 2\,CO_2 + 2\,e^-$

$2\,Fe^{3+} + 2e^- \rightarrow 2\,Fe^2$

Das entstandene Eisen in der Oxidationsstufe II ist dann in der Lage z.B. aus einer Palladiumchloridlösung Palladiumkeime abzuscheiden; gemäss der Formel

$2\,Fe^{2+} + Pd^{2+} \rightarrow 2\,Fe^{3+} + Pd^0$.

Ein Nachteil dieses Photopromotors ist die Anwesenheit von Eisen in der Oxidationsstufe II, mit welchem die Eisen(III)-salze im Gleichgewicht stehen. Das ohne eine Belichtung vorhandene Eisen(II) wirkt im Sinne der obigen Gleichung keimbildend und kann Anlass für Wildwuchs sein. Wildwuchs ist eine nichtbeabsichtigte Metallabscheidung an nicht dafür vorgesehenen Stellen einer Oberfläche. Dieser Nachteil ist vermeidbar durch Zugabe eines Oxidationsmittels, z.B. Salpetersäure, in Spurenmengen welches das unerwünschte Eisen(II) in Eisen(III) überführen soll. Bei einer möglichen Überdosis des Oxidationsmittels, z.B. der Salpetersäure, wird in nachteiliger Weise das durch eine Belichtung erzeugte $Fe^{2+}$-Ion sofort wieder in ein $Fe^{3+}$-Ion überführt, so dass keine Keimbildung möglich ist. Ein derartiges Verfahren ist wirtschaftlich nicht anwendbar.

Aus der DE-OS 2 518 520 ist es bekannt, als lichtempfindliche Sensibilisatoren kolloide Lösungen der Oxidhydrate von Palladium, Indium, Cer, Nickel, Mangan, Uran, Molybdän und Wolfram zu verwenden. Ein Nachteil dieser kolloidalen Lösungen besteht darin, dass durch die verschiedensten Ursachen eine Ausflockung der kolloidal gelösten Komponenten stattfinden kann. Die Wahrscheinlichkeit einer Ausflockung steigt mit der Anzahl und Konzentration der Fremdstoffe, z.B. Staubkörner.

Der Erfindung liegt daher die Aufgabe zugrunde, ein gattungsgemässes Verfahren dahingehend zu verbessern, dass eine wirtschaftliche sowie störungsunempfindliche chemische Metallisierung möglich wird, insbesondere bei der industriellen Massenfertigung elektronischer Leiterplatten.

Diese Aufgabe wird gelöst durch die im kennzeichnenden Teil des Patentanspruchs 1 angegebenen Merkmale. Ausgestaltungen und Weiterbildungen sind den Unteransprüchen entnehmbar.

Ein erster Vorteil der Erfindung besteht darin, dass der erfindungsgemässe Sensibilisator weitgehenst unempfindlich ist gegenüber dem Luftsauerstoff. Dadurch werden insbesondere bei der industriellen Fertigung keine besonderen Schutzmassnahmen, z.B. die Anwendung eines Schutzgases, für das Sensibilisatorbad erforderlich. Ausserdem wird die Lebensdauer des Sensibilisatorbades wesentlich erhöht.

Ein zweiter Vorteil besteht darin, dass das zur Keimbildung erforderliche Nichtedelmetall bei dem unbelichteten Sensibilisator lediglich in einer einzigen Oxidationsstufe vorliegt. Dadurch ist insbesondere bei der Musterübertragung in einer Leiterplattenfertigung ein weiter Belichtungsspielraum möglich. Eine Anpassung der Belichtungsbedingungen an den Zustand des Sensibilisatorbades z.B. dessen Alters, wird vermieden.

Ein dritter Vorteil ergibt sich daraus, dass der Sensibilisator als wässrige Lösung anwendbar ist und nicht als kolloidale Lösung angewendet werden muss. Dadurch wird eine störende Ausflokkung, z.B. durch Verunreinigungen der zu metallisierenden Substrate, vermieden, die Lebensdauer des Sensibilisatorbades wird wesentlich gesteigert.

Ein vierter Vorteil besteht darin, dass das Reduktionsmittel unmittelbar an das zu reduzierende Metallion gebunden ist. Dadurch wird der Elektronenübergang bei der durch die Belichtung initiierten Redoxreaktion wesentlich erleichtert. Dadurch wird vorteilhafterweise die Quantenausbeute gesteigert, was einem höheren Reaktionsumsatz äquivalent ist. Daraus folgt, dass insbesondere bei einer räumlich selektiven Belichtung eine kurze Belichtungszeit und/oder eine geringe Lichtintensität der Belichtungsquelle benötigt werden. Dadurch wird ein wirtschaftlich sowie kostengünstig durchführbares Belichtungsverfahren möglich.

Ein fünfter Vorteil besteht darin, dass es möglich ist, den unbelichteten Sensibilisator entweder ganzflächig auf eine Substratoberfläche aufzutragen und diese dann räumlich selektiv zu belichten, z.B. zur Herstellung sehr schmaler elektrischer Leiterbahnen, oder den Sensibilisator räumlich selektiv auf die Substratoberfläche aufzutragen, z.B. mit Hilfe eines Schreibstiftes oder eines Druckverfahrens. Im letzten Fall wird dann die Substratoberfläche im wesentlichen als Ganzes belichtet.

Die Erfindung beruht darauf, dass der Sensibilisator ein Edelmetallsalz enthält und eine Chrom(III)-Komplexverbindung, bei der die Liganden, wenn sie mit Licht geeigneter Wellenlänge bestrahlt werden, reduzierend auf das Chrom mit der Oxidationszahl drei wirken. Das während der Belichtung entstandene Chrom der Oxidationsstufe zwei wirkt dann unmittelbar reduzierend auf die im Edelmetallsalz enthaltenen Edelmetallionen. Es entstehen Keime aus Edelmetall, die für eine nachfolgende aussenstromlose Metallisierung erforderlich sind. Das im unbelichteten Sensibilisator enthaltene Chrom(III)-Ion besitzt in erwünschter Weise ein grosse chemische Stabilität. So wird Chrom(II) in wässrigen Lösungen von Luftsauerstoff zu Chrom(III) oxidiert. Auch unter Luftausschluss findet eine Oxidation zu Chrom(III) statt, indem Wasser unter Freisetzen von Wasserstoff reduziert wird. Chrom wird also in dem unbelichteten Sensibilisator ausschliesslich mit der Oxidationszahl +3 vorliegen. Daraus ergibt sich eine hervorragende Langzeitstabilität solcher Lösungen. Das Fehlen von Chrom der Oxidationsstufe +2 beim unbelichteten Sensibilisator ist besonders wichtig, da Chrom(II) zu unerwünschten Keimen, wie beschrieben, führen würde und damit die Ursache für Wildwuchs bzw. für die Zerstörung der aussenstromlosen Metallisierungsbäder wäre.

Die für die beschriebenen Redoxreaktionen notwendige Aktivierungsenergie muss durch Strahlung mit Wellenlängen kleiner as 400 nm aufgebracht werden, vorzugsweise durch UV-Strahlung. Längerwellige Strahlung reicht zur Aktivierung nicht aus. Sie ist auch nicht erwünscht, da bei ihr der Einfluss des natürlichen Lichts die Handhabung erschweren würde. Für ein Absorptionsmaximum zwischen 250 und 260 nm wird als bevorzugtes Beispiel der Erfindung ein Trioxalatochromat(III)-Palladium(II)-chlorid Sensibilisator angegeben. Das angegebene Maximum erlaubt zur Belichtung die Verwendung von monochromatischem kohärenten UV-Laserlicht. Der Vorteil des Lasers liegt in der hohen Energiedichte und der möglichen berührungsfreien Bildübertragung von der Vorlage auf die Substratoberfläche ohne nennenswerte Streueffekte. Ausserdem zeigen viele Quecksilberdampflampen Emissionsmaixma in diesem Wellenlängenbereich.

Durch die Kombination von Chrom in der Oxidationsstufe III mit einem Edelmetallsalz wird nach der Belichtung direkt die Bildung stabiler Edelmetallkeime ermöglicht. Diese Bildung kann durch eine weitere Lösung von Edelmetallsalzen unterstützt werden. Bei schwacher Lichtintensität ist durch einen Reifungsprozess eine Vergrösserung der Keime möglich. In den nachfolgend angewandten chemischen Metallisierungsbädern muss dann die entstandene metallische Keimschicht nur noch auf die beabsichtigte Schichtdikke verstärkt werden.

Die Erfindung wird anhand der folgenden Ausführungsbeispiele näher erläutert.

Beispiel 1

Leiterplatten-Basismaterial, z.B. glasfaserverstärkte Epoxidharzplatten, wird in bekannter Weise gereinigt und gebeizt. Die Sensibilisierung für UV-Licht erfolgt durch Eintauchen in eine Sensibilisatorlösung, die insbesondere in Abhängigkeit von dem verwendeten Basismaterial sowie dessen Vorbehandlung, auf folgende Weise hergestellt wird:

1 bis 10 g Natriumoxalat und 1 bis 18 g Chrom(III)-chlorid werden in 500 ml demineralisiertem Wasser gelöst. Dazu werden 500 ml einer wässrigen Lösung von 0,1 bis 2 g/l Palladium(II)-chlorid, 1 bis 100 ml/l 37%ige Salzsäure und 100 bis 800 mg/l Netzmittel gegeben. Wenn die Mischung einen rötlichen Farbton angenommen hat, kann sie benutzt werden.

Danach wird das beschichtete Substrat getrocknet. Durch eine Negativmaske mit dem zu erzeugenden Leitermuster wird das sensibilisierte Basismaterial mit UV-Licht einer Quecksilberdampf-Hochdrucklampe bestrahlt. Bereits hier lässt sich andeutungsweise eine Abbildung des Leitermusters erkennen. Dieses wird mit einer wässrigen Lösung behandelt, die pro Liter 0,1 bis 0,9 g Palladium(II)-chlorid, 1 bis 100 ml 37%ige Salzsäure und 10 bis 200 mg eines Netzmittels enthält. Danach wird eine selektive chemische Metallisierung in einem derzeit handelsüblichen aussenstromlos arbeitenden Kupferbad durchgeführt, bis die gewünschte Leiterstärke erreicht ist.

Beispiel 2

Entsprechend Beispiel 1, nur dass zur Belichtung ein fokussierter UV-Laserstrahl mit einer Wellenlänge zwischen 250 und 260 nm benutzt wird, der räumlich ablenkbar ist und dessen Intensität modulierbar ist. Die zugehörige Steuerung und/oder Regelung wird mit Hilfe einer Datenverarbeitungsanlage durchgeführt, in welcher das zu erzeugende Leitermuster (Oberflächenmuster) gespeichert ist.

Alternativ zu dem ablenkbaren Laserstrahl ist es möglich, diesen ortsfest zu halten und das zu belichtende Basismaterial (Substrat) zu bewegen, z.B. mit Hilfe eines Kreuztisches, der von der Datenverarbeitungsanlage gesteuert wird, entsprechend dem zu erzeugenden Muster.

Beispiel 3

Entsprechend Beispiel 1, nur dass zunächst die unbelichtete Sensibilisatorlösung räumlich selektiv auf das Leiterplatten-Basismaterial (Substrat) aufgetragen wird, entsprechend dem zu erzeugenden Oberflächenmuster (Leitermuster). Das derart beschichtete Substrat wird anschliessend im wesentlichen ganzflächig mit UV-Licht des Wellenlängenbereiches 250 nm bis 260 nm belichtet und entsprechend dem Beispiel 1 weiterbehandelt.

Das räumlich selektive Beschichten ist auf vielfältige Weise möglich, z.B. mit Hilfe eines handgeführten Pinsels und/oder eines Tintenschreibstiftes, der mit der Sensibilisatorlösung gefüllt wird. Ausserdem ist es möglich, einen entsprechend gestalteten und mit der Sensibilisatorlösung gefüllten Schreibstift an einem sogenannten Plotter einer Datenverarbeitungsanlage zu befestigen und damit das Substrat zu beschichten entsprechend dem zu erzeugenden Muster. Als Belichtungsquelle ist dann nahezu jede grossflächig strahlende UV-Quelle geeignet, z.B. eine Haushaltshöhensonne.

Ein derartiges Verfahren ist insbesondere geeignet zur kostengünstigen Herstellung von Kleinserien und/oder Versuchsmustern. Eine für UV-Licht geeignete Belichtungsmaske und/oder fokussiertes UV-Licht werden vermieden.

Beispiel 4

Wie Beispiel 1, nur dass zur Sensibilisierung ein Gemisch aus Natriumtrioxalatochromat(III), Palladium(II)-chlorid und Polyvinylalkohol verwendet wird.

Beispiel 5

Wie Beispiel 1, nur dass zur Sensibilisierung ein Gemisch aus Kaliumtrioxalatochromat(III), Gold(III)-chlorid und Pentaerythrit verwendet wird.

Beispiel 6

Wie Beispiel 1, nur dass vor der Dickverkupferung eine selektive Vormetallisierung in einem Nickel-Phosphor-Legierungsbad folgender Zusammensetzung stattfindet:

15 g/l $NiSO_4 \cdot 6\ H_2O$
15 g/l Borax
17 g/l Citronensäure
30 g/l Natriumhypophosphit

mit demineralisiertem Wasser auf 1 l aufgefüllt und mit NaOH auf pH 9 eingestellt.

**Patentansprüche**

1. Verfahren zur chemischen Metallisierung, insbesondere zur selektiven Metallisierung einer elektrisch isolierenden Substratoberfläche, bei dem ein Oberflächenmuster eines für eine aussenstromlose Metallisierung katalytisch wirksamen Metalls gebildet wird durch Belichten eines auf die Substratoberfläche aufgebrachten strahlungsempfindlichen Sensibilisators, der anschliessend mit einer Salzlösung des katalytisch wirksamen Metalls behandelt wird, dadurch gekennzeichnet, dass der Sensibilisator mindestens ein Edelmetallsalz und mindestens eine Chrom(III)-Komplexverbindung enthält, deren Liganden während des Belichtens ein Reduktionsmittel zumindest für Chrom(III)-Ionen bilden.

2. Verfahren zur chemischen Metallisierung nach Anspruch 1, dadurch gekennzeichnet, dass in dem unbelichteten Sensibilisator zwischen dem Chrom(III)-Ion und dem Edelmetall ein Molverhältnis eingestellt wird, das im Bereich von 10:1 bis 1:10 liegt.

3. Verfahren zur chemischen Metallisierung nach Anspruch 1 oder Anspruch 2, dadurch gekennzeichnet, dass als Chrom(III)-Komplexverbindung ein Trioxalatochromat(III) verwendet wird.

4. Verfahren zur chemischen Metallisierung nach einem der vorhergehenden Ansprüche, dadurch gekennzeichnet, dass ein Edelmetallsalz ausgewählt wird, das Gold und/oder Iridium und/oder Osmium und/oder Palladium und/oder Platin und/oder Rhodium und/oder Ruthenium und/oder Silber enthält.

5. Verfahren zur chemischen Metallisierung nach einem der vorhergehenden Ansprüche, dadurch gekennzeichnet, dass die Substratoberfläche zunächst im wesentlichen ganzflächig mit dem Sensibilisator beschichtet wird und dass der Sensibilisator anschliessend nach Massgabe des zu erzeugenden Oberflächenmusters räumlich selektiv belichtet wird mit einer Strahlung, deren Wellenlänge kleiner als 400 nm ist.

6. Verfahren zur chemischen Metallisierung nach einem der vorhergehenden Ansprüche, dadurch gekennzeichnet, dass zunächst der Sensibilisator nach Massgabe des zu erzeugenden Oberflächenmusters räumlich selektiv auf die Substratoberfläche aufgebracht wird und dass anschliessend die derart beschichtete Substratoberfläche im wesentlichen ganzflächig belichtet wird mit der Strahlung, deren Wellenlänge kleiner als 400 nm ist.

7. Verfahren zur chemischen Metallisierung nach einem der vorhergehenden Ansprüche, dadurch gekennzeichnet, dass zum Belichten eine Strahlung verwendet wird, deren Wellenlänge im wesentlichen im Bereich von 250 nm bis 260 nm liegt.

8. Verfahren zur chemischen Metallisierung nach einem der vorhergehenden Ansprüche, dadurch gekennzeichnet, dass die durch belichtete Bereiche des Sensibilisators räumlich selektiv aktivierte Substratoberfläche in einem aussenstromlos arbeitenden Metallisierungsbad selektiv metallisiert wird.

9. Verfahren zur chemischen Metallisierung nach einem der vorhergehenden Ansprüche, dadurch gekennzeichnet, dass zumindest die belichteten Bereiche des Sensibilisators zunächst mit einem Nickel-Phosphor-Legierungsbad behandelt werden und anschliessend die gewünschte Metallisierung vorgenommen wird.

**Claims**

1. Method for the chemical metallising, in particular for the selective metallising of an electrically insulating substrate surface, in which a surface pattern of a metal, which is catalytically effective for a metallising without external current, is formed by illumination of a radiation-sensitive sensitizer, which had been applied onto the substrate surface and is afterwards treated with a salt solution of the catalytically effective metal, characterised thereby, that the sensitizer contains at least one noble metal salt and at least one complex chromium (III) compound, the ligands of which during the illumination form a reducing agent at least for chromium (III) ions.

2. Method for the chemical metallising according to claim 1, characterised thereby, that a molar ratio, which lies in the range of 10:1 to 1:10, is set between the chromium (III) ion and the noble metal in the unilluminated sensitizer.

3. Method for the chemical metallising according to claim 1 or claim 2, characterised thereby, that a trioxalatochromate (III) is used as complex chromium (III) compound.

4. Method for the chemical metallising according to one of the preceding claims, characterised thereby, that a noble metal salt is selected, which contains gold and/or iridium and/or osmium and/or palladium and/or platinum and/or rhodium and/or ruthenium and/or silver.

5. Method for the chemical metallising according to one of the preceding claims, characterised thereby, that the substrate surface is initially coated over the substantially entire area by the sensitizer and that the sensitizer is afterwards spatially selectively illuminated by a radiation, the wavelength of which is smaller than 400 nanometres, in accordance with the surface pattern to be produced.

6. Method for the chemical metallising according to one of the preceding claims, characterised thereby, that the sensitizer is initially applied spatially selectively onto the substrate surface in accordance with the surface pattern to be produced and that the substrate surface coated in such a manner is afterwards illuminated over the substantially entire area by a radiation, the wavelength of which is smaller than 400 nanometres.

7. Method for the chemical metallising according to one of the preceding claims, characterised thereby, that a radiation, the wavelength of which lies substantially in the range of 250 nanometres to 260 nanometres, is used for the illuminating.

8. Method for the chemical metallising according to one of the preceding claims, characterised thereby, that the substrate surface, spatially selectively activated by illuminated regions of the sensitizer, is metallised selectively in a metallising bath operating without external current.

9. Method for the chemical metallising according to one of the preceding claims, characterised thereby, that at least the illuminated regions of the sensitizer are initially treated with a nickel-phosphor alloy bath and the desired metallising is undertaken afterwards.

**Revendications**

1. Procédé de métallisation chimique, en particulier de métallisation sélective de la surface d'un support isolant de l'électricité, dans lequel on forme, par exposition à la lumière d'un sensibilisant sensible aux rayonnements appliqué à la surface du support, un modèle superficiel d'un métal catalytique actif dans une métallisation sans application de courant, qui est ensuite traité par une solution de sel du métal catalytique actif, caractérisé en ce que le sensibilisant contient au moins un sel de métal noble et au moins un complexe de chrome-III dont les ligands forment, lors de l'exposition à la lumière, un agent réducteur, au moins pour les ions de chrome-III.

2. Procédé de métallisation chimique selon la revendication 1, caractérisé en ce que l'on règle dans le sensibilisant non exposé à la lumière un rapport molaire de 10:1 à 1:10 entre l'ion de chrome-III et le métal noble.

3. Procédé de métallisation chimique selon la revendication 1 ou 2, caractérisé en ce que l'on utilise en tant que complexe de chrome-III un trioxalatochromate-III.

4. Procédé de métallisation chimique selon l'une des revendications qui précèdent, caractérisé en ce que l'on choisit un sel de métal noble contenant de l'or et/ou de l'iridium et/ou de l'osmium et/ou du palladium et/ou du platine et/ou du rhodium et/ou du ruthénium et/ou de l'argent.

5. Procédé de métallisation chimique selon l'une des revendications qui précèdent, caractérisé en ce que la surface du support est d'abord revêtue essentiellement sur toute sa surface par l'agent sensibilisant, lequel est ensuite exposé à la lumière sélectivement dans l'espace en correspondance avec le modèle superficiel à produire, par un rayonnement à une longueur d'onde inférieure 400 nm.

6. Procédé de métallisation chimique selon l'une des revendications qui précèdent, caractérisé en ce que le sensibilisant est d'abord appliqué sélectivement dans l'espace, en correspondance avec le modèle superficiel à produire, sur la surface du support, laquelle est ensuite exposée toute entière à la lumière à un rayonnement de longueur d'onde inférieur à 400 nm.

7. Procédé de métallisation chimique selon l'une des revendications qui précèdent, caractérisé en ce que l'on utilise pour l'exposition un rayonnement dont la longueur d'onde se situe essentiellement dans l'intervalle de 250 à 260 nm.

8. Procédé de métallisation chimique selon l'une des revendications qui précèdent, caractérisé en ce que la surface du support, activée sélectivement dans l'espace par les régions exposées à la lumière du sensibilisant, est métallisée sélectivement dans un bain de métallisation opérant sans application de courant.

9. Procédé de métallisation chimique selon l'une des revendications qui précèdent, caractérisé en ce que l'on traite d'abord au moins les régions exposées à la lumière du sensibilisant par un bain d'alliage nickel-phosphore puis on procède à la métallisation voulue.